(19) **Europäisches Patentamt**
**European Patent Office**
**Office européen des brevets**

(11) **EP 1 868 214 B1**

(12) **EUROPEAN PATENT SPECIFICATION**

(45) Date of publication and mention
of the grant of the patent:
**26.01.2011 Bulletin 2011/04**

(51) Int Cl.:
**H01F 7/18** (2006.01)

(21) Application number: **07075427.0**

(22) Date of filing: **01.06.2007**

(54) **Direct flux control system for magnetic structures**

System zur direkten Flussregelung für magnetische Strukturen

Système de commande des flux directs pour structures magnétiques

(84) Designated Contracting States:
**AT BE BG CH CY CZ DE DK EE ES FI FR GB GR
HU IE IS IT LI LT LU LV MC MT NL PL PT RO SE
SI SK TR**

(30) Priority: **13.06.2006 US 451953**

(43) Date of publication of application:
**19.12.2007 Bulletin 2007/51**

(73) Proprietor: **Delphi Technologies, Inc.
Troy, Michigan 48007 (US)**

(72) Inventors:
• **Nehl, Thomas Wolfgang
Shelby Township, MI 48316 (US)**

• **Gopalakrishnan, Suresh
Farmington Hills, MI 48335 (US)**
• **Deng, Fang
Novi, MI 48375 (US)**

(74) Representative: **Fox-Male, Nicholas Vincent
Humbert et al
Patent Outsourcing Limited
1 King Street
Bakewell
Derbyshire DE45 1DZ (GB)**

(56) References cited:
**WO-A-00/45403       WO-A-93/11369
DE-A1- 19 505 219    GB-A- 2 259 188
JP-A- 6 249 991      JP-A- 62 060 488
US-A- 4 659 969      US-A- 4 665 348**

Printed by Jouve, 75001 PARIS (FR)

**Description**

TECHNICAL FIELD

The present application relates to systems for controlling magnetic structures and, more particularly, to systems for controlling the amount of force generated by solenoid-type magnetic structures using direct flux control.

BACKGROUND OF THE INVENTION

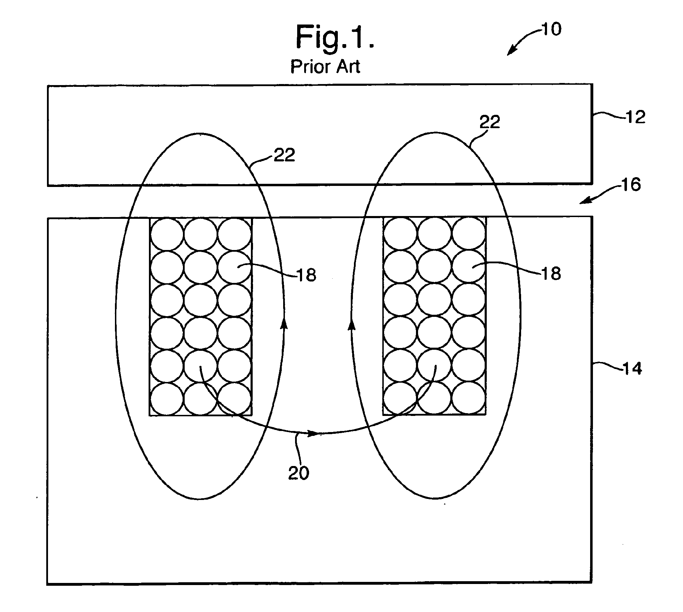

Solenoid-type magnetic structures have been embodied in various devices, such as magnetorheological fluid dampers, control valves, fuel injectors and the like. As shown in Fig. 1, a typical solenoid-type magnetic structure, generally designated 10, may include two cores 12, 14 separated by a small air gap 16. A coil 18 may be wound onto one of the cores 14 such that, as an electric current 20 flows through the coil 18, a magnetic flux 22 is generated in the gap 16.

The resulting force generated by the magnetic structure 10 may be a function of the density of the magnetic flux 22 within the gap 16. For example, the force generated by a linear motion actuator (not shown) may be proportional to the square of the flux density in the gap 16. In magnetorheological devices, the force may be a linear function of the flux density in the gap. Therefore, the amount of force generated by a solenoid-type magnetic structure may be controlled by controlling the current 20 passing through the coil 18.

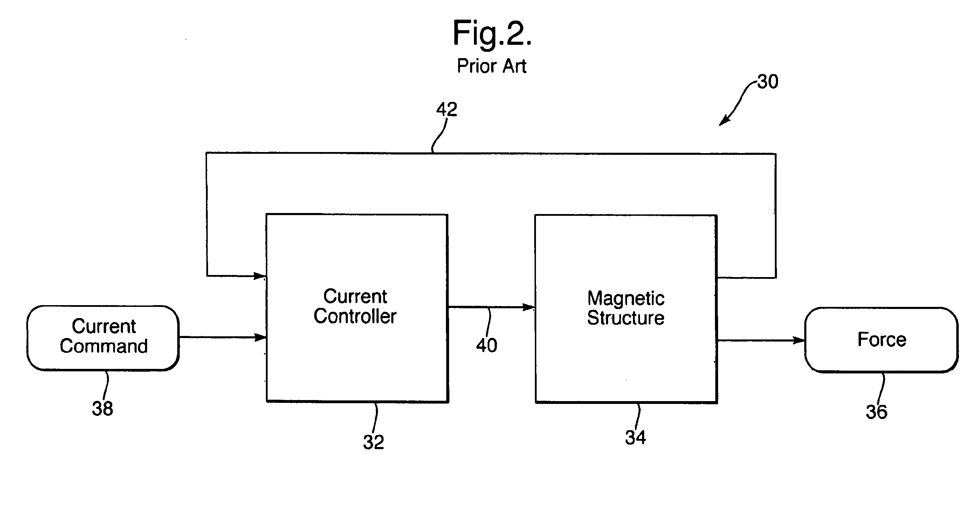

Referring to Fig. 2, a typical feedback system 30 for controlling flux response may include a current controller 32 for controlling a magnetic structure 34 to achieve a desired force 36 in response to a current command 38. The current controller 32 may be a pulse width modulation controller or the like and may generate a coil voltage command 40 (note: the coil current is a function of the coil voltage) in response to the current command 38 and the current feedback data 42 received from the magnetic structure 34.

Ideally, the density of magnetic flux in the gap 16 will follow the coil current without time delay. However, when controlling flux response using current control, the effects of induced eddy currents and hysteresis within the structure may be significant and may delay the overall flux response. For example, induced eddy currents may require a longer time interval to decay than the coil current, thereby delaying the overall flux response of the system and negatively affecting the dynamic performance of the magnetic structure.

Accordingly, there is a need for an improved system for controlling the flux response of magnetic structures.

US-A-4665348, US-A-4659969, GB-A-2259188 and DE-A-19505219 disclose a flux control system with a unidirectional current flow system where current is increasing or is zero.

SUMMARY OF THE INVENTION

In one aspect, a flux control system includes a magnetic structure including a coil adapted to generate a magnetic flux in response to an electric current passing therethrough; an electric circuit coupled to said coil to supply said electric current to said coil, said electric circuit being configured to supply said electric current in both a positive direction and a negative direction; a current controller in communication with said electric circuit, said current controller being configured to control said electric current supplied by said electric circuit based, at least in part, upon a current command and a first feedback signal indicative of said electric current in said coil; and a flux controller configured to generate said current command based, at least in part, upon an input flux command and a second feedback signal indicative of said magnetic flux generated by said coil.

Other aspects of the disclosed direct flux control system will become apparent from the following description, the accompanying drawings and the appended claims.

BRIEF DESCRIPTION OF THE DRAWINGS

Fig. 1 is an elevational view of a prior art magnetic structure;

Fig. 2 is a block diagram of a prior art flux response control system;

Fig. 3 is a block diagram of a flux response control system according to an aspect of the disclosed direct flux control system;

Fig. 4 is a graphical illustration of air gap flux versus time according to the control system of Fig. 3 as compared with the control system of Fig. 2;

Fig. 5 is a graphical illustration of coil current versus time according to the control system of Fig. 3 as compared with the control system of Fig. 2;

Fig. 6 is an elevational view of a magnetic structure according to an alternative aspect of the disclosed direct flux control system;

Fig. 7 is a schematic view of one aspect of a system for providing bidirectional current drive in the flux response control system of Fig. 3; and

Fig. 8 is a schematic view of a second aspect of a system for providing bidirectional current drive in the flux response control system of Fig. 3.

DESCRIPTION OF THE PREFERRED EMBODIMENTS

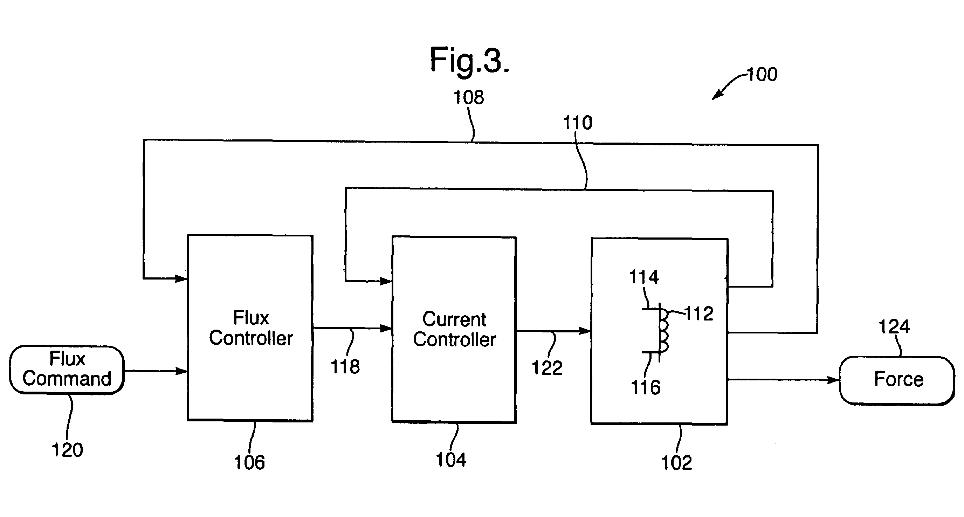

As shown in Fig. 3, an improved system for controlling flux response, generally designated 100, may include a controllable magnetic structure 102, a current controller 104 and a flux controller 106. A flux feedback loop 108 may be provided to communicate flux data from the magnetic structure 102 to the flux controller 106. An electric current feedback loop 110 may be provided to communicate electric current data from the magnetic structure 102 to the current controller 104.

The flux controller 106 may be any device or processor capable of generating a command in response to input data. For example, the flux controller 106 may be a pulse width modulation-type controller, a PID controller or the like. Furthermore, those skilled in the art will appreciate that the flux controller 106 and the current controller 104 may be separate control units or, alternatively, may be associated with a single controller and/or processing unit.

In one aspect, the controllable magnetic structure 102 may include a coil 112 adapted to generate a magnetic field when an electric current passes therethrough. For example, the controllable magnetic structure 102 may be a solenoid-type magnetic structures, such as a magnetorheological fluid damper, a control valve, a fuel injector (e.g., a diesel injector) or the like, and may include a solid core. The coil 112 is according to the invention a bidirectional coil and may include two ungrounded terminals 114, 116 such that current may flow in two directions through the coil 112.

The flux controller 106 may be adapted to generate a command 118 (e.g., a current command) in response to an input flux command 120 and the flux data provided by the flux feedback loop 108. In turn, the current controller 104 may be adapted to generate a command 122 (e.g., a voltage) in response to the command 118 and the current data provided by the current feedback loop 110, which may induce a current in the coil 112. Therefore, the magnetic structure 102 may generate a force 124 proportional to the input flux command 120. Systems for generating and controlling the current in the coil 112 are described in greater detail herein.

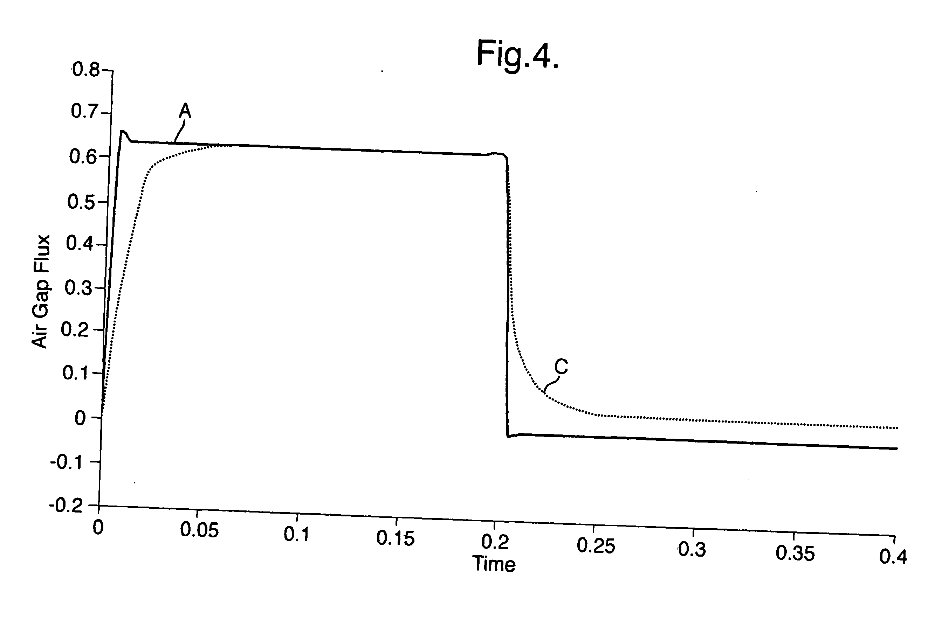

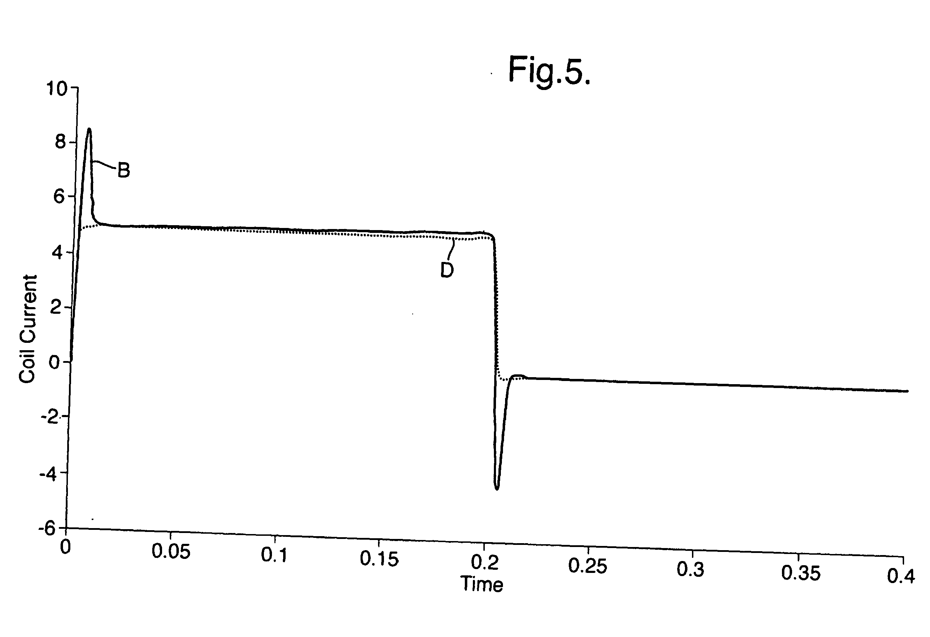

For example, referring to Figs. 4 and 5, a magnetorheological fluid damper was configured with the flux control system 100 described above. The input flux command 120 was changed from 0 Wb to 0.65 Wb at time t=0 seconds and at time t=0.2 seconds the input flux command 120 was changed from 0.65 Wb to 0 Wb. The resulting air gap flux versus time is plotted as a solid line A in Fig. 4 and the resulting electric current within the coil 112 is shown as a solid line B in Fig. 5. For comparison, the same commands were repeated using current control (i.e., no direct flux control) and the results are shown by a broken line C in Fig. 4 and a broken line D in Fig. 5. It is clear from C, to those skilled in the art, that without flux control the flux does not return to zero due to the magnetic hysteresis of the core material.

Thus, those skilled in the art will appreciate that by controlling the flux directly, as described above, the effects of induced eddy currents and hysteresis within the magnetic structure may have little or no influence on the flux response, thereby providing a more robust system having a magnetic flux profile that closely follows the input flux command with little or no time delay.

The electric current data of the current feedback loop 110 may be obtained using any available means, including an ammeter adapted to directly measure the current in the magnetic structure (e.g., current passing through the coil 112) and communicate the current data to the current controller 104 by way of the current feedback loop 110. Likewise, the flux data of the flux feedback loop 108 may be obtained using any available means and may be measured or estimated.

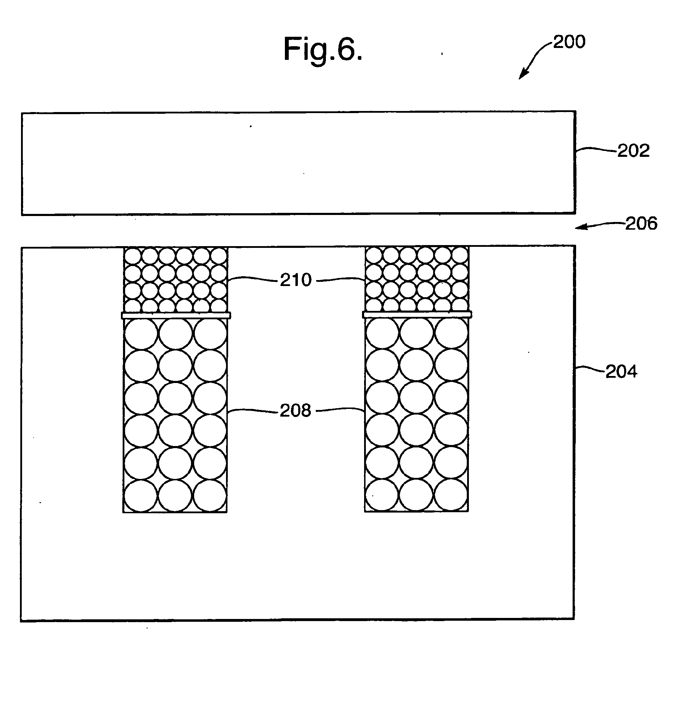

Referring to Fig. 6, an alternative aspect of a magnetic structure, generally designated 200, may include two cores 202, 204 separated by a small air gap 206. A main coil 208 may be wound onto one of the cores 204 and a separate search coil 210 may be wound adjacent to, or around, the main coil 208 and as close to the air gap 206 as possible so as to accurately measure the total air gap flux. As a controlled electric current flows through the main coil 208, a magnetic flux may be generated in the gap 206.

The magnetic flux in the air gap 206 may generate a voltage $V_{sc}$ in the search coil 210 as follows:

$$V_{sc} = N\frac{d\varphi}{dt} \qquad (Eq. 1)$$

wherein N is the number of turns of the search coil 210, $\varphi$ is the magnetic flux in the air gap 206 and t is time. Therefore, the magnetic flux $\varphi$ in the air gap 206 may be determined through integration as follows:

$$\varphi = \frac{1}{N}\int V_{SC}dt \qquad \text{(Eq. 2)}$$

Thus, in one aspect, a search coil 210 may be used to provide a true measurement of the magnetic flux in the air gap 206.

In another aspect, the magnetic flux in the air gap 206 may be related to the voltage $V_{Mc}$ of the main coil 208 as follows:

$$V_{MC} = Ri_{coil} + N\frac{d\varphi}{dt} \qquad \text{(Eq. 3)}$$

wherein R is the resistance of the main coil 208 and associated wiring, $i_{coil}$ is the current in the main coil 208, N is the number of turns of the main coil 210, $\varphi$ is the magnetic flux in the air gap 206 and t is time. Therefore, the magnetic flux $\varphi$ in the air gap 206 may be determined through integration as follows:

$$\varphi = \frac{1}{N}\int(V_{MC} - Ri_{coil})dt \qquad \text{(Eq. 4)}$$

Thus, a true measurement of the magnetic flux in the air gap 206 may be obtained without the need for an additional search coil 210.

In another aspect, the magnetic flux in the air gap 206 may be estimated using a mathematical model of the coil dynamics to determine estimated values of the eddy currents and determining magnetic flux based upon measurements of the coil current combined with the estimated eddy current values.

Accordingly, by feeding back flux data to a controller capable of controlling the coil current, whether the flux feedback data is measured or estimated, the lag times associated with eddy currents and hysteresis may be overcome.

As discussed above, the coil 112 (Fig. 3) of the magnetic structure 102 of the disclosed flux control system 100 is associated with a bidirectional system that allows current flow in two directions through the coil (e.g., both positive and negative current flow), as shown, for example, by solid line B in Fig. 5.

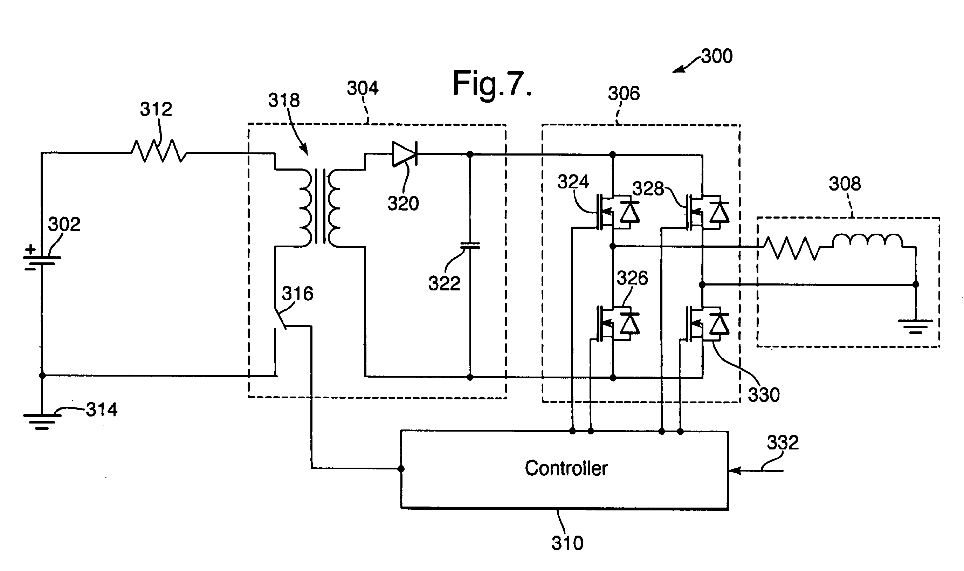

As shown in Fig. 7, one aspect of a system for providing bidirectional current drive, generally designated 300, may include a power source 302, a fly back converter 304, an H-bridge inverter 306, a grounded coil 308 and a controller 310. The system 300 may have a resistance 312.

The power source 302 may be a battery or the like and may be connected to ground 314 (e.g., a vehicle chassis). The fly back converter 304 may include a switch 316, a transformer 318, a diode 320 and a capacitor 322. The switch 316 may be in communication with the controller 310 such that the controller may open and close the switch as required. The fly back converter 304 may electrically isolate the power source 302 from the H-bridge 306 and may step-up the voltage supplied by the power source 302. For example, the fly back converter 304 may generally double the voltage supplied by the power source 302.

The H-bridge 306 may include four power switches 324, 326, 328, 330, each of which may be connected to the controller 310. The power switches 324, 326, 328, 330 may be any available power switches, such as MOSFET power switches or the like.

In response to an input signal 332 (e.g., command 118 of Fig. 3), the controller 310 may open or close the switch 316 as necessary and may actuate power switches 324, 330 to achieve current flow through the grounded coil 308 in a first direction. When opposite current flow through the coil 308 is desired, the controller 310 may deactivate power switches 324, 330 and actuate power switches 326, 328.

Thus, system 300 may provide an increased voltage and a bidirectional current through a grounded coil 308.

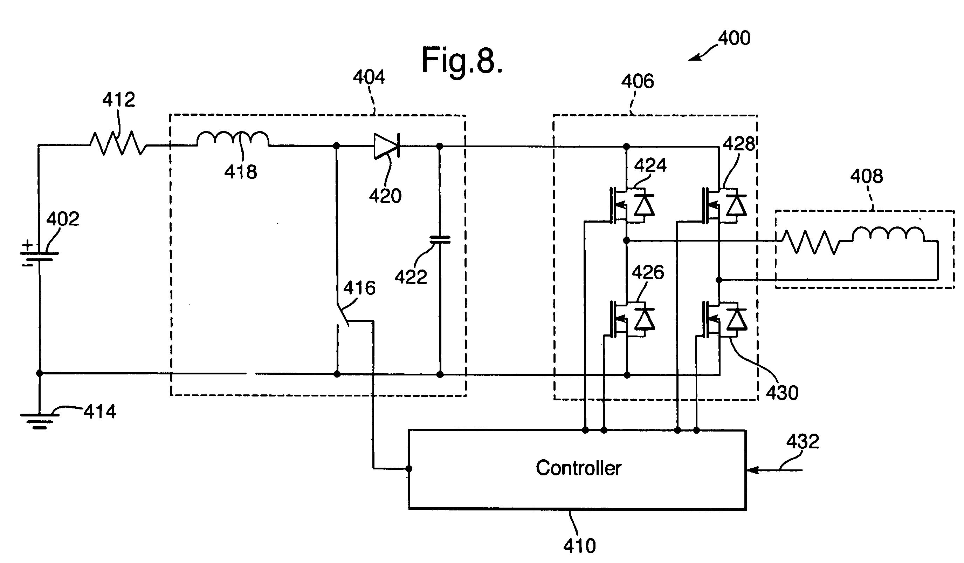

As shown in Fig. 8, an alternative system for providing bidirectional current drive, generally designated 400, may include a power source 402, a boost converter 404, an H-bridge inverter 406, an ungrounded coil 408 and a controller 410. The system 400 may have a resistance 412.

The boost converter 404 may include a switch 416, an inductor 418, a diode 420 and a capacitor 422. The switch 416 may be in communication with the controller 410 such that the controller may open and close the switch as required. The boost converter 404 may step-up the voltage supplied by the power source 402 to the H-bridge 406. For example, the boost converter 404 may generally double the voltage supplied by the power source 402.

**EP 1 868 214 B1**

The H-bridge 406 may include four power switches 424, 426, 428, 430, each of which may be connected to the controller 410. In response to an input signal 432 (e.g., command 118 of Fig. 3), the controller 410 may open or close the switch 416 as necessary and may actuate power switches 424, 430 to achieve current flow through the ungrounded coil 408 in a first direction. When opposite current flow through the coil 408 is desired, the controller 410 may deactivate power switches 424, 430 and actuate power switches 426, 428.

Thus, system 400 may provide an increased voltage and a bidirectional current through an ungrounded coil 408.

Full flux control requires bidirectional control of the current.

Although various aspects of the disclosed direct flux control system have been shown and described, modifications may occur to those skilled in the art upon reading the specification.


**Claims**

1.   A flux control system (100) comprising:

   a magnetic structure (102) including a coil (112) adapted to generate a magnetic flux in response to an electric current passing therethrough;
   an electric circuit coupled to said coil to supply said electric current to said coil, said electric circuit being configured to supply said electric current in both a positive direction and a negative direction;
   a current controller (104) in communication with said electric circuit, said current controller being configured to control said electric current supplied by said electric circuit based, at least in part, upon a current command (118) and a first feedback signal (110) indicative of said electric current in said coil; and
   a flux controller (106) configured to generate said current command based, at least in part, upon an input flux command and a second feedback signal (108) indicative of said magnetic flux generated by said coil (112).

2.   The flux control system of claim 1 wherein said flux controller (106) and said current controller (104) are associated with a single processing unit.

3.   The flux control system of claim 1 wherein said magnetic structure (102) is a solenoid-type magnetic structure.

4.   The flux control system of claim 3 wherein said solenoid-type magnetic structure includes at least one solid core.


**Patentansprüche**

1.   Flusssteuerungssystem (100), aufweisend:

   eine Magnetstruktur (102), die eine Spule (112) aufweist, die angepasst ist, um einen magnetischen Fluss in Antwort auf einen dort hindurch laufenden elektrischen Strom zu erzeugen;
   einen elektrischen Schaltkreis, der mit der Spule gekoppelt ist, um den elektrischen Strom an die Spule zu liefern, wobei der elektrische Schaltkreis eingerichtet ist, um den elektrischen Strom sowohl in einer positiven Richtung als auch einer negativen Richtung zu liefern;
   eine Stromsteuerung (104) in Kommunikation mit dem elektrischen Schaltkreis, wobei die Stromsteuerung eingerichtet ist, den elektrischen Strom, der durch den elektrischen Schaltkreis geliefert wird, basierend, zumindest teilweise, auf einem Strombefehl (118) und einem ersten Rückkopplungssignal (110), das indikativ für den elektrischen Strom in der Spule ist, zu steuern; und
   eine Flusssteuerung (106), die eingerichtet ist, den Strombefehl basierend, zumindest teilweise, auf einem Eingangsflussbefehl und einem zweiten Rückkopplungssignal (108), das indikativ für den magnetischen Fluss ist, der durch die Spule (112) erzeugt wird, zu erzeugen.

2.   Flusssteuerungssystem gemäß Anspruch 1, wobei die Flusssteuerung (106) und die Stromsteuerung (104) einer einzigen Verarbeitungseinheit zugeordnet sind.

3.   Flusssteuerungssystem gemäß Anspruch 1, wobei die Magnetstruktur (102) eine Solenoid-Magnetstruktur ist.

4.   Flusssteuerungssystem gemäß Anspruch 3, wobei die Solenoid-Magnetstruktur zumindest einen massiven Kern aufweist.

**Revendications**

1. Système de contrôle de flux (100), comprenant :

   une structure magnétique (102) incluant une bobine (112) adaptée pour générer un flux magnétique en réponse à un courant électrique circulant à travers elle;
   un circuit électrique couplé à ladite bobine pour fournir ledit courant électrique à ladite bobine électrique, ledit circuit électrique étant configuré pour fournir ledit courant électrique à la fois dans le sens positif et dans le sens négatif ;
   un régulateur de courant (104) communiquant avec ledit circuit électrique, ledit régulateur de courant étant configuré pour contrôler ledit courant électrique fourni par ledit circuit électrique basé, au moins en partie, sur une commande de courant (118) et un premier signal de retour (110) indiquant ledit courant électrique dans ladite bobine ; et
   un contrôleur de flux (106) configuré pour générer ladite commande de courant, au moins en partie sur une commande de flux entrante et un deuxième signal de retour (108) indiquant ledit flux magnétique généré par ladite bobine (112).

2. Système de contrôle de flux selon la revendication 1, dans lequel ledit contrôleur de flux (106) et ledit régulateur de courant (104) sont associés à un seul processeur.

3. Système de contrôle de flux selon la revendication 1, dans lequel la structure magnétique (102) est une structure magnétique de type à solénoïde.

4. Système de contrôle de flux selon la revendication 3, dans lequel la structure magnétique de type à solénoïde inclut au moins un noyau plein.

# Fig.1.
## Prior Art

# Fig.2.
## Prior Art

EP 1 868 214 B1

# Fig.3.

EP 1 868 214 B1

Fig.4.

Fig.5.

## Fig.6.

200

202

206

210

208

204

Fig.7.

# Fig.8.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4665348 A
- US 4659969 A
- GB 2259188 A
- DE 19505219 A